# EUROPEAN PATENT SPECIFICATION

(11) **EP 3 249 354 B1**
(45) Date of publication and mention of the grant of the patent: **19.08.2020**
(21) Application number: 17162619.5
(22) Date of filing: 23.03.2017
(51) Int. Cl.: G01C 19/574, G01C 19/5733, F16F 7/10, F16F 7/104, G01P 15/097, B81B 7/00

(54) **SYSTEMS AND METHODS FOR A TUNED MASS DAMPER IN MEMS RESONATORS**
SYSTEME UND VERFAHREN FÜR EINEN ABGESTIMMTEN MASSENDÄMPFER IN MEMS-RESONATOREN
SYSTÈMES ET PROCÉDÉS POUR UN AMORTISSEUR DE MASSE ACCORDÉ DANS DES RÉSONATEURS MEMS

(30) Priority: 26.05.2016 US 201662342125 P; 22.03.2017 US 201715466774
(43) Date of publication of application: 29.11.2017
(73) Proprietor: Honeywell International Inc., Morris Plains, NJ 07950 (US)
(72) Inventor: GNERLICH, Markus Hans, Morris Plains, NJ 07950 (IS); JOHNSON, Burgess R., Morris Plains, NJ 07950 (US); CHRIST, Kevin V., Morris Plains, NJ 07950 (US)
(74) Representative: Houghton, Mark Phillip

(56) References cited:
- EP-A1- 2 963 387
- DE-A1-102011 085 294
- US-A1- 2007 034 005
- US-A1- 2007 068 756
- US-A1- 2008 001 075
- US-A1- 2010 295 414
- US-A1- 2011 303 007

## Description

### STATEMENT REGARDING FEDERALLY SPONSORED RESEARCH OR

### DEVELOPMENT

This invention was made with Government support under Government Contract Number HR0011-16-9-0001 awarded by DARPA. The Government has certain rights in the invention.

### CROSS REFERENCE TO RELATED APPLICATIONS

This application claims the benefit of United States Provisional Patent Application Serial No. 62/342,125, filed on May 26, 2016.

### BACKGROUND

Ideally, certain MEMS sensors, including vibratory MEMS sensors such as MEMS gyroscopes, would produce zero net vibration external to the sensor mechanism. However, imperfections may be introduced during fabrication of the MEMS sensor and the mounting of the MEMS sensor to the sensor package. For example, imperfections may include etch variations across a wafer which may introduce a degree of non-symmetry in the vibrating masses. The non-symmetry may produce a net external vibration. Since the mounting fixture and sensor mechanism are mechanically coupled, a non-symmetry in the mounting fixture may transform a portion of the linear vibration into a measureable rotational component. This additional rotational component introduces a non-compensatable bias into the gyro output.

EP2963387A1 discloses damping forces acting on a suspended mass of a MEMS gyroscope by including a dampening mass in an opening formed in the suspended mass. US2007/0034005A1 discloses a micro-machined gyroscope with two proof masses but no tuned mass damper. US2011/03007A1 discloses a MEMS gyroscope with no tuned mass damper. US2007/0068756A1 discloses an active vibration damping system.

### SUMMARY

The present invention, in its various aspects, is as set out in the appended claims. Systems and methods for a tuned mass damper in MEMS resonators are provided.

### DRAWINGS

Understanding that the drawings depict only exemplary embodiments and are not therefore to be considered limiting in scope, the exemplary embodiments will be described with additional specificity and detail through the use of the accompanying drawings, in which:
FIGS. 1A-1C are block diagrams illustrating MEMS sensors having a tuned mass damper, wherein figures 1B and 1C corresond to examples not forming part of the invention;
FIG. 2 is a diagram illustrating the proof masses of a MEMS sensor in conjunction with a tuned mass damper according to one or more embodiments described herein;
FIG. 3 is a diagram illustrating the proof masses of a MEMS sensor in conjunction with multiple tuned mass dampers configured to suppress rotational vibrations according to one or more embodiments described herein;
FIG. 4 is a diagram illustrating the proof masses of a MEMS sensor in conjunction with multiple tuned mass dampers according to one or more embodiments described herein;
FIG. 5 is a flow diagram illustrating a method for suppressing undesirable vibration modes according to one or more embodiments described herein.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

To remove vibrations caused by imperfections in fabrication, a tuned mass damper may be used to reduce harmonic vibrations caused by the imperfections. A tuned mass damper (TMD) consists of an additional mass and spring connected to a larger assembly. The tuned mass damper has the net effect of reducing the harmonic vibration of the assembly at one or more frequencies. The frequency of the mass/spring system of the TMD is tuned to a frequency to reduce harmonic vibration by naturally resonating out of phase with the main assembly. The amplitude of the vibration of the smaller TMD is relatively large and the combined inertia of the TMD system results in a lower vibration amplitude of the larger assembly. In at least one implementation, the TMD may be used in a dual mass tuning fork vibratory micro-electrical mechanical systems (MEMS) gyroscope where the tuned mass damper may be placed between two primary vibrating masses. As there may be some asymmetry between the physical characteristics of the two primary masses in the larger assembly, the tuned mass damper, placed in between the two primary masses may suppress undesirable side-to-side vibration that is transmitted to the gyroscope package/chassis, while antisymmetric tuning fork vibration may be unaffected. Further, the use of a tuned mass damper may be used to suppress the motion of multiple gyro modes that are excited by imperfections in the tuning fork mode motion along the x-axis, for example, quadrature sense mode motion, symmetric z-axis motion, symmetric y-axis motion, etc. The TMD may be configured to have damping combs. Alternatively, the TMD may be configured without damping combs.

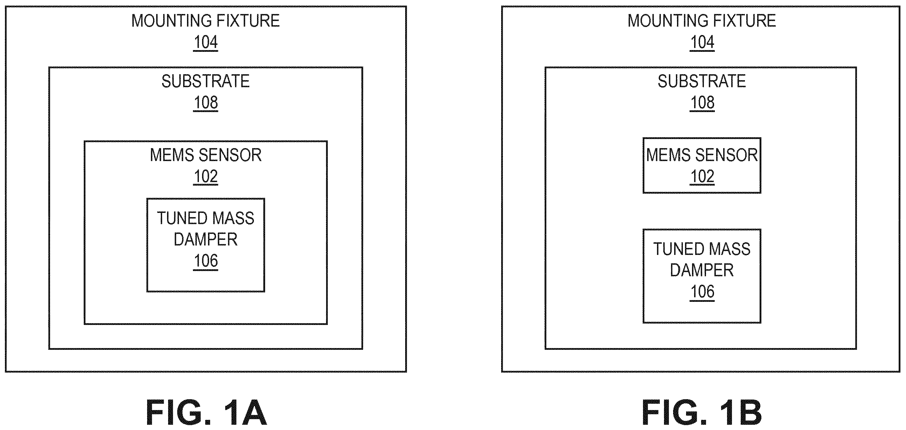

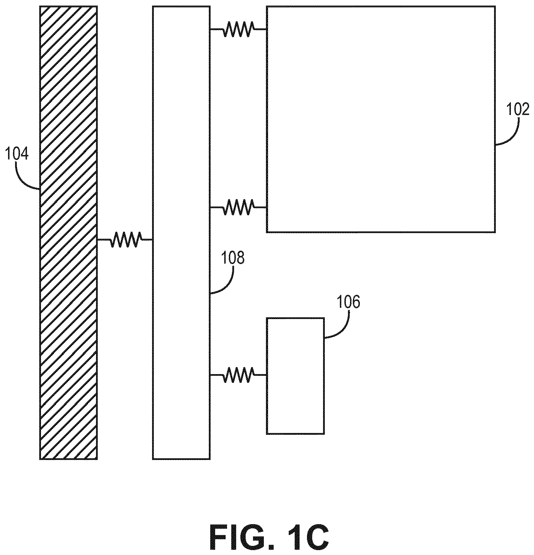

FIG. 1A is a block diagram of a MEMS sensor mounting fixture 104 having a tuned mass damper 106 as part of the MEMS sensor 102. The MEMS sensor 102 may be a dual mass tuning fork vibratory MEMS gyroscope, an out of plane gyroscope, in plane gyroscopes, vibrating beam accelerometers, or other MEMS sensors or actuators where the output of a structure is dependent on a vibrating structure. When there are fabrication imperfections in the MEMS sensor 102 or imperfections with the mounting of the MEMS sensor 102 to a substrate 108 or the mounting of the substrate to the mounting fixture 104, unintended vibrations in the MEMS sensor 102 and mounting fixture 104 may be created. The unintended vibrations may introduce a non-compensatable bias into the sensor output. As shown in FIG. 1A, a tuned mass damper 106 may be incorporated as part of the MEMS sensor 102. The flexures connecting the tuned mass damper 106 may be tuned such that the tuned mass damper 106 is able to counter-act vibrations caused by the imperfections that may cause spurious signals in the output from the MEMS sensor 102. In at least one implementation, the tuned mass damper 106 is a passive tuned mass damper, however, in alternative implementations, the tuned mass damper 106 may be a mass that is actively driven by a force that is based on the output of a control loop designed to suppress undesired vibrations. Alternatively, the TMD may have a damping mechanism attached thereto, such that the TMD may absorb vibration energy. FIG. IB illustrates a different implementation of a tuned mass damper 106, where the tuned mass damper 106 is not fabricated as part of the MEMS sensor 102 but rather mounted next to the MEMS sensor 102 on the substrate 108. For example, FIG. 1C provides a side view of a tuned mass damper 106 mounted to the substrate 108 as shown in FIG. IB. As illustrated, the substrate 108 may be a silicon or glass substrate that is bump bonded to the mounting fixture 104. Alternatively, the mounting fixture 104 may be connected to the substrate 108 through one or more flexures. Both the proof masses of the MEMS sensor 102 and the tuned mass damper 106 may then be free standing MEMS structures connected to the substrate 108.

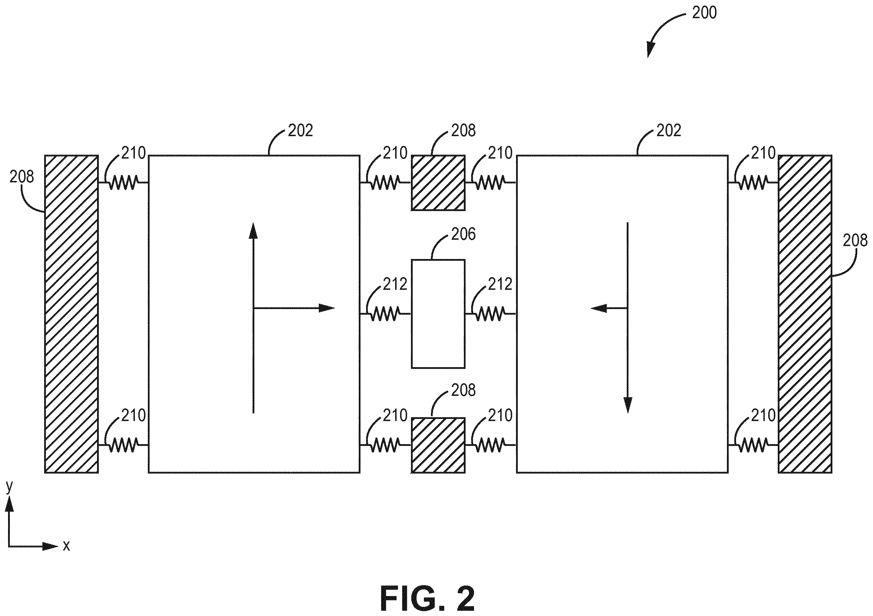

FIG. 2 is a block diagram illustrating one implementation for a MEMS sensor 200, where the MEMS sensor 200 includes a dual mass tuning fork gyroscope. As illustrated, the dual mass tuning fork gyroscope may include a pair of proof masses 202. Each proof mass 202 may be a planar member defining two major surfaces on reverse sides of their respective proof masses 202. Further, in some implementations, each proof mass may have combs mounted to at least two opposite edges. One of the combs may have tines that are interleaved with a comb of a respective in-plane drive electrode. Alternatively, the combs may be interleaved with drive electrodes disposed out-of-plane from the proof masses 202, as described in U.S. Patent No. 7,036,373, which is titled "MEMS Gyroscope with Horizontally Oriented Drive Electrodes". A second of the combs of each proof mass 202 may be interleaved with a comb of an in-plane motor pickoff electrode.

In further implementations, a pair of upper sense electrodes may be disposed out-of-plane from the proof masses 202. Likewise a pair of lower sense electrodes may be disposed out-of-plane from the proof masses 202 on an opposite side of the proof mass 202 from the upper sense electrodes. Alternatively, for an out-of-plane MEMS gyroscope, the sense electrodes may consist of sense combs disposed in-plane from the proof masses 202 and interleaved with sense combs attached to the proof masses 202. Both the upper and lower sense electrodes are proximate to a respective side of the proof masses 202. Also, each of the proof masses 202 is suspended by support flexures 210 permitting movement of the proof masses 202 relative to the in-plane motor pickoff electrode and the out-of-plane sense electrodes or in-plane sense combs. Further, to conter-act vibrations due to imperfections in the fabrication and mounting of the MEMS sensor 200, each of the proof masses 202 may be connected to a tuned mass damper 206. Each of the proof masses 202 is connected to opposite sides of the tuned mass damper 206 through flexures 212 that extend between the tuned mass damper 206 and the proof masses 202. Further, the proof masses 202 are supported by the support flexures 210 that connect to anchors 208. The anchors 208 are mounted to a supporting substrate.

In certain embodiments, during operation, respective AC drive signals are applied to drive electrodes to induce in-plane motion on the respective proof masses 202. The in-plane motion of the respective proof masses 202 induces an in-plane signal through the in-plane motor pickoff electrode. In at least one implementation, control electronics may be coupled to the motor pickoff electrode and configured to process the in-plane signal to adjust the AC drive signals to maintain a desired magnitude and frequency for the in-plane motion of the proof masses 202.

Respective voltages may be applied between the sense electrodes and their corresponding proof masses 202 in order to sense out-of-plane motion of the proof masses 202 for an in-plane MEMS gyroscope, or in-plane motion for an out-of-plane MEMS gyroscope. For example, at a given moment in time a positive voltage can be applied between the proof masses 202 and a respective upper sense electrode proximate to a first side of the proof masses 202 and a negative voltage can be applied between the proof masses 202 and a respective lower sense electrode proximate a second side of the proof masses 202. The voltage difference between the upper and lower sense electrodes and the respective proof masses 202 may induce an out-of-plane signal for the proof masses 202 when the proof masses 202 move out-of-plane. Further control electronics may be coupled to the MEMS sensor 200 and may be configured to process the out-of-plane signal to determine a rotation rate for the proof masses 202 among other things. As the proof masses 202 are both coupled to a tuned mass damper 206, the tuned mass damper 206 may be tuned to counter-act asymmetric vibrations due to imperfections in fabrication and mounting that may affect the rotation rate.

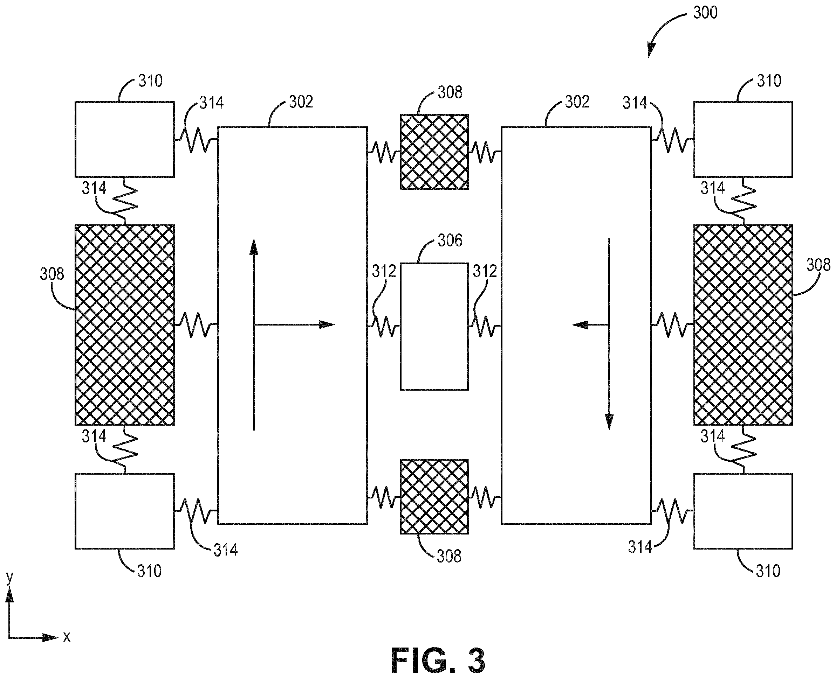

FIG. 3 is a diagram illustrating a MEMS sensor 300 having multiple tuned mass dampers 306 and 310. The tuned mass damper 306 is similar to the tuned mass damper 206 described above with regards to FIG. 2. Further, the MEMS sensor 300 may also include tuned mass dampers 310. In contrast to tuned mass damper 306, tuned mass dampers 310 are located at positions within the MEMS sensor 300 such that they are able to counter-act rotational vibrations due to imperfections in the MEMS sensor 300. For example, the tuned mass dampers 310 may be placed around the perimeter of the MEMS sensor such that they are able to vibrate tangentially to the rotation vibrations of the MEMS sensor 300. Accordingly, the proof masses 302 are connected to the tuned mass damper 306 through flexures 312 and tuned mass dampers 310 through flexures 314, where the tuned mass dampers 310 may or may not be coupled to anchors 308. Thus, the tuned mass dampers 306 and 310 may suppress undesirable mechanical modes that may negatively impact performance of a gyro, even if the undesirable mode is created from sources other than the interaction of the MEMS sensor with a chassis.

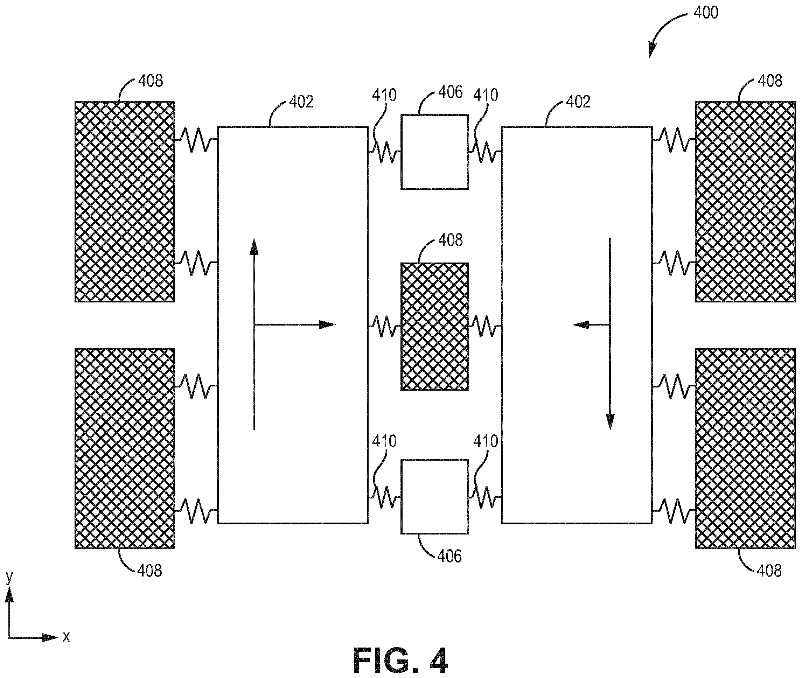

FIG. 4 is a diagram illustrating a MEMS sensor 400 having multiple tuned mass dampers 406. As illustrated, each of the proof masses 402 may be coupled to multiple tuned mass dampers 406 through flexures 410. This is in contrast to the single tuned mass damper 202 described in FIG. 2. As illustrated, a MEMS sensor may have any arrangement of tuned mass dampers that are able to reduce undesirable mechanical modes. Further, the proof masses 402 may also be coupled to anchors 408.

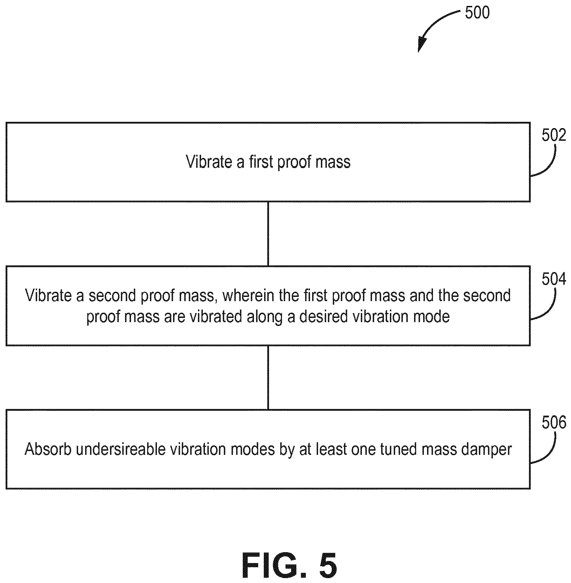

FIG. 5 is a flow diagram for a method 500 for suppressing undesirable vibration modes in a MEMS sensor. Method 500 proceeds at 502, where a first proof mass is vibrated. Method 500 then proceeds at 504, where a second proof mass is vibrated, wherein the first proof mass and the second proof mass are vibrated along a desired vibration mode. In at least one implementation, the first proof mass and the second proof mass are coupled to a substrate through a plurality of flexures and the first proof mass and the second proof mass are vibrated along desired vibration modes. Further, method 500 proceeds at 506, where undesirable vibration modes are counter-acted by a tuned mass damper. For example, the tuned mass damper may be coupled to the first proof mass and the second proof mass through flexures. Also, tuned mass dampers may be arranged along the perimeter of the MEMS sensor to counter-act rotational vibrations.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the appended claims.

## Claims

1. A system for suppressing undesirable vibration modes, the system comprising:
a micro-electrical mechanical system (MEMS) resonator (102), the MEMS resonator (102) comprising:
two or more proof masses (202, 402);
a plurality of anchors (208, 408), wherein proof masses (202, 402) in the two or more proof masses (202, 402) are connected to the plurality of anchors (208, 408) through a plurality of flexures (210, 410);
a substrate (108), wherein the MEMS resonator (102) is mounted to the substrate (108) through the plurality of anchors (208, 408); and
one or more tuned mass dampers (106, 206, 406) configured to counter-act the undesirable vibration modes in the substrate (108) and the MEMS resonator (102),
**characterized in that**
the one or more tuned mass dampers comprise a first mass coupled to a first proof mass in the two or more proof masses (202) through a first flexure (212, 410) that extends between the first mass and the first proof mass and to a second proof mass in the two or more proof masses (202) through a second flexure (212, 410) that extends between the first mass and the second proof mass, wherein the first mass is placed between the first proof mass and the second proof mass, and the first proof mass and the second proof mass are connected to opposite sides of the first mass.

2. The system of claim 1, wherein the one or more tuned mass dampers (106, 406) comprise a second mass that is coupled to the first proof mass through a third flexure (410) and to the second proof mass through a fourth flexure (410).

3. A method for suppressing undesirable vibration modes in a micro-electrical mechanical sensor (MEMS) resonator (102), the method comprising:
vibrating a first proof mass;
vibrating a second proof mass, wherein the first proof mass and the second proof mass are coupled to a substrate (108) through a plurality of flexures (210) and the first proof mass and the second proof mass are vibrated along a desired vibration mode; and
counter-acting undesirable vibration modes in at least one of the MEMS resonator (102) and the substrate (108) by one or more tuned mass dampers (106, 206, 406)
**characterized in that** the one or more tuned mass dampers comprise a first mass that is coupled to the first proof mass through a first flexure (212, 410) that extends between the first mass and the first proof mass and to the second proof mass through a second flexure (212, 410) that extends between the first mass and the second proof mass, wherein the first mass is placed between the first proof mass and the second proof mass and the first proof mass and the second proof mass are connected to opposite sides of the first mass.

4. The method of claim 3, wherein the one or more tuned mass dampers (106, 206, 406) comprise a second mass that is coupled to the first proof mass through a third flexure (410) and to the second proof mass through a fourth flexure (410).

## Patentansprüche

1. System zur Unterdrückung unerwünschter Vibrationsmodi, wobei das System umfasst:
einen mikroelektrischen mechanischen System (MEMS)-Resonator (102), wobei der MEMS-Resonator (102) umfasst:
zwei oder mehr Prüfmassen (202, 402);
eine Vielzahl von Ankern (208, 408), wobei Prüfmassen (202, 402) in den zwei oder mehreren Prüfmassen (202, 402) durch eine Vielzahl von Biegungen (210, 410) mit der Vielzahl von Ankern (208, 408) verbunden sind;
ein Substrat (108), wobei der MEMS-Resonator (102) durch die Vielzahl von Ankern (208, 408) an dem Substrat (108) angebracht ist; und
ein oder mehrere abgestimmte Massendämpfer (106, 206, 406), die konfiguriert sind, um den unerwünschten Vibrationsmodi im Substrat (108) und im MEMS-Resonator (102) entgegenzuwirken,
**dadurch gekennzeichnet, dass**
der eine oder die mehreren abgestimmten Massendämpfer eine erste Masse umfassen, die mit einer ersten Prüfmasse in den zwei oder mehreren Prüfmassen (202) durch eine erste Biegung (212, 410), die sich zwischen der ersten Masse und der ersten Prüfmasse erstreckt, und mit einer zweiten Prüfmasse in den zwei oder mehreren Prüfmassen (202) durch eine zweite Biegung (212, 410) gekoppelt ist, die sich zwischen der ersten Masse und der zweiten Prüfmasse erstreckt, wobei die erste Masse zwischen der ersten Prüfmasse und der zweiten Prüfmasse platziert ist und die erste Prüfmasse und die zweite Prüfmasse mit entgegengesetzten Seiten der ersten Masse verbunden sind.

2. System nach Anspruch 1, wobei der eine oder die mehreren abgestimmten Massendämpfer (106, 406) eine zweite Masse umfassen, die mit der ersten Prüfmasse durch eine dritte Biegung (410) und mit der zweiten Prüfmasse durch eine vierte Biegung (410) gekoppelt ist.

3. Verfahren zum Unterdrücken unerwünschter Vibrationsmodi in einem mikroelektrischen mechanischen Sensor (MEMS)-Resonator (102), wobei das Verfahren umfasst:
Versetzen einer ersten Prüfmasse in Vibrationen;
Versetzen einer zweiten Prüfmasse in Vibrationen, wobei die erste Prüfmasse und die zweite Prüfmasse durch eine Vielzahl von Biegungen (210) mit einem Substrat (108) gekoppelt sind und die erste Prüfmasse und die zweite Prüfmasse entlang eines gewünschten Vibrationsmodus in Vibrationen versetzt werden; und
Entgegenwirken derunerwünschten Vibrationsmodi in mindestens einem von dem MEMS-Resonator (102) und dem Substrat (108) durch einen oder mehrere abgestimmte Massendämpfer (106, 206, 406)
**dadurch gekennzeichnet, dass** der eine oder die mehreren abgestimmten Massendämpfer
eine erste Masse umfassen, die mit der ersten Prüfmasse durch eine erste Biegung (212, 410) gekoppelt ist, die sich zwischen der ersten Masse und der ersten Prüfmasse erstreckt, und mit der zweiten Prüfmasse durch eine zweite Biegung (212, 410), die sich zwischen der ersten Masse und der zweiten Prüfmasse erstreckt, wobei die erste Masse zwischen der ersten Prüfmasse und der zweiten Prüfmasse platziert ist, und die erste Prüfmasse und die zweite Prüfmasse mit gegenüberliegenden Seiten der ersten Masse verbunden sind.

4. Verfahren nach Anspruch 3, wobei der eine oder die mehreren abgestimmten Massendämpfer (106, 206, 406) eine zweite Masse umfassen, die mit der ersten Prüfmasse durch eine dritte Biegung (410) und mit der zweiten Prüfmasse durch eine vierte Biegung (410) gekoppelt ist.

## Revendications

1. Système de suppression de modes indésirables de vibration, le système comprenant :
un résonateur (102) de système mécanique microélectrique (MEMS), le résonateur MEMS (102) comprenant :
au moins deux masses d'épreuve (202, 402) ;
une pluralité d'ancrages (208, 408), des masses d'épreuve (202, 402) dans les au moins deux masses d'épreuve (202, 402) étant reliées à la pluralité d'ancrages (208, 408) par l'intermédiaire d'une pluralité de joints flexibles (210, 410) ;
un substrat (108) sur lequel est monté le résonateur MEMS (102) à travers la pluralité d'ancrages (208, 408) ; et
au moins un amortisseur de masse accordé (106, 206, 406), conçu pour contre-agir sur les modes indésirables de vibration dans le substrat (108) et dans le résonateur MEMS (102),
**caractérisé en ce que**
lesdits amortisseurs de masse accordés comprennent une première masse accouplée à une première masse d'épreuve parmi les au moins deux masses d'épreuve (202) à travers un premier joint flexible (212, 410), qui s'étend entre la première masse et la première masse d'épreuve, et à une seconde masse d'épreuve parmi lesdites masses d'épreuve (202) à travers un deuxième joint flexible (212, 410) qui s'étend entre la première masse et la seconde masse d'épreuve, la première masse étant placée entre la première masse d'épreuve et la seconde masse d'épreuve et la première masse d'épreuve et la seconde masse d'épreuve étant reliées aux côtés opposés de la première masse.

2. Système selon la revendication 1, dans lequel lesdits amortisseurs de masse accordés (106, 406) comprennent une seconde masse qui est accouplée à la première masse d'épreuve à travers un troisième joint flexible (410) et à la seconde masse d'épreuve à travers un quatrième joint flexible (410).

3. Procédé de suppression de modes indésirables de vibration dans un résonateur (102) de capteur mécanique microélectrique (MEMS), le procédé comprenant :
la vibration d'une première masse d'épreuve ;
la vibration d'une seconde masse d'épreuve, la première masse d'épreuve et la seconde masse d'épreuve étant accouplées à un substrat (108) à travers une pluralité de joint flexibles (210) et la première masse d'épreuve et la seconde masse d'épreuve vibrant selon un mode de vibration souhaité ; et
la contre-action de modes indésirables de vibration dans le résonateur MEMS (102) et/ou dans le substrat (108) par au moins un amortisseur de masse accordé (106, 206, 406) ;
**caractérisé en ce que** lesdits amortisseurs de masse accordés
comprennent une première masse qui est accouplée à la première masse d'épreuve à travers un premier joint flexible (212, 410), qui s'étend entre la première masse et la première masse d'épreuve, et à la seconde masse d'épreuve à travers un deuxième joint flexible (212, 410) qui s'étend entre la première masse et la seconde masse d'épreuve, la première masse étant placée entre la première masse d'épreuve et la seconde masse d'épreuve et la première masse d'épreuve et la seconde masse d'épreuve étant reliées aux côtés opposés de la première masse.

4. Procédé selon la revendication 3, dans lequel lesdits amortisseurs de masse accordés (106, 206, 406) comprennent une seconde masse qui est accouplée à la première masse d'épreuve à travers un troisième joint flexible (410) et à la seconde masse d'épreuve à travers un quatrième joint flexible (410).
